# EUROPÄISCHE PATENTSCHRIFT

(11) **EP 2 568 605 B1**
(45) Veröffentlichungstag und Bekanntmachung des Hinweises auf die Patenterteilung: **26.02.2020**
(21) Anmeldenummer: 12182141.7
(22) Anmeldetag: 29.08.2012
(51) Int. Cl.: H03K 17/955, H03K 17/96

(54) **Kapazitive Sensoranordnung**
Capacitative sensor assembly
Agencement de capteur capacitif

(30) Priorität: 06.09.2011 DE 102011053314
(43) Veröffentlichungstag der Anmeldung: 13.03.2013
(73) Patentinhaber: Huf Hülsbeck & Fürst GmbH & Co. KG, 42551 Velbert (DE)
(72) Erfinder: Sieg, Berthold, 46240 Bottrop (DE); Van Gastel, Peter, 42699 Solingen (DE); Lindic, Iko, 45149 Essen (DE); Peschl, Andreas, 42555 Velbert (DE)
(74) Vertreter: Zenz Patentanwälte Partnerschaft mbB

(56) Entgegenhaltungen:
- EP-A1- 0 518 836
- EP-A2- 1 164 240
- US-A1- 2011 001 549

## Beschreibung

Die Erfindung betrifft eine kapazitive Annäherungssensoranordnung mit wenigstens einer beabstandet zu einer Referenzelektrode angeordneten Sensorelektrode und einer Richtelektrode sowie einer mit der wenigstens einen Sensorelektrode, der Richtelektrode und der Referenzelektrode verbundenen Steuerschaltung, wobei die Steuerschaltung eine Messschaltung zum Messen der Kapazität der wenigstens einen Sensorelektrode gegenüber der Referenzelektrode aufweist.

Ferner betrifft die Erfindung ein Verfahren zum Betreiben eines kapazitiven Annäherungssensors, der wenigstens eine beabstandet zu einer Referenzelektrode angeordnete Sensorelektrode und eine Richtelekrode aufweist und mit einer mit der wenigstens einen Sensorelektrode, der Richtelektrode und mit der Referenzelektrode verbundenen Steuerschaltung gekoppelt ist, wobei die Kapazität der wenigstens einen Sensorelektrode gegenüber der Referenz von einer Messschaltung der Steuerschaltung gemessen wird.

Eine Sensorelektronik der eingangs genannten Art wird beispielsweise verwendet, um die Annäherung der Hand eines Bedieners (Fahrers) an einen Türaußengriff eines Kraftfahrzeugs zu erfassen. Beim Erfassen der Annäherung der Hand des Bedieners initiiert eine in dem Kraftfahrzeug angeordnete Steuerelektronik eine Funkabfrage eines von dem Bediener mitgeführten ID-Gebers (elektronischen Schlüssels), d.h. eines Transponders oder Funksendeempfängers, den der Bediener bei sich trägt (beispielsweise in einer Tasche der Kleidung oder in einer Aktentasche). Diese Funkabfrage wird zum Beispiel mit Hilfe des Aussendens eines Funksignals in einem Frequenzbereich von beispielsweise 125 kHz, d.h. einem LF-Frequenzbereich, ausgeführt, wobei zum Abstrahlen eine Spule verwendet wird, die beispielsweise innerhalb des Türgriffs angeordnet ist. Der ID-Geber empfängt, sofern er sich im Empfangsbereich der Sendespule befindet, das Funksignal, erkennt darin eine Aufforderung zur Identifizierung und sendet daraufhin seinerseits in einem höheren Frequenzbereich (beispielsweise im Megahertz-Frequenzbereich) ein Antwortsignal, welches einen den ID-Geber identifizierenden Code umfasst. Das Steuergerät des Kraftfahrzeugs empfängt diese Antwort, überprüft den Code und gibt daraufhin die Betätigung des Türschlosses mit Hilfe des vom Bediener ergriffenen Türgriffes frei. Der die Annäherung des Bedieners erfassende Sensor wird somit insbesondere deshalb eingesetzt, damit nicht ständig von der Sendespule ein Abfragesignal ausgesendet werden muss. Das Abfragesignal wird nur dann ausgesendet, wenn die Annäherung eines Körperteils des Bedieners erfasst worden ist.

Eine derartige Sensoranordnung kann andererseits beispielsweise auch bei einer Einklemmschutzeinrichtung für eine von einem Antrieb bewegbare Tür oder Klappe Anwendung finden. Solche Anwendungen sowie eine kapazitive Annäherungssensoranordnung der eingangs genannten Art sind beispielsweise in der Veröffentlichung EP 1 164 240 A2 bzw. der Veröffentlichung DE 10 2006 044 778 A1 beschrieben.

Ein entsprechender kapazitiver Annäherungssensor ist weiterhin in der Druckschrift EP 1 339 025 A1 oder in der Druckschrift EP 1 235 190 beschrieben. Ferner ist ein Grundprinzip des Sensors beispielsweise in der Druckschrift US 5,730,165 A offenbart.

Wesentlich bei solchen Sensoren ist die Auswertung der Kapazität, welche durch den in den Erfassungsbereich eindringenden Körper verändert wird. Eine Messschaltung zum Messen der Kapazität einer Sensorelektrode gegenüber Masse bei einem solchen Annäherungssensor ist beispielsweise in der Patentschrift DE 196 81 725 B4 beschrieben.

Um die Empfindlichkeit eines eine Sensorelektrode aufweisenden kapazitiven Sensors zu verbessern bzw. um die Sensorreichweite zu vergrößern, wurde vorgeschlagen, zwischen der Sensorelektrode und der Kraftfahrzeugseitig dahinter befindlichen metallischen Massefläche (eine Massefläche kann auch in einer Schaltung innerhalb des Türgriffs vorhanden sein) eine abschirmende Metallfläche, den Elektrodenschild oder die Schirmelektrode, vorzusehen, wobei das Potential dieser abschirmenden Metallfläche mittels einer Spannungsverfolgerschaltung dem Potential der Sensorelektrode nachgeführt wird (ohne dass die beiden Elektroden unmittelbar miteinander gekoppelt sind). Eine derartige aktive Abschirmung ist beispielsweise in der Druckschrift EP 0 518 836 A1 beschrieben.

Diese Schildwirkung entfaltet die Elektrode, wenn sie zwischen Masse und Sensorelektrode platziert und in ihrem Potenzial der Sensorelektrode nachgeführt wird. In dieser Konstellation werden die elektrischen Feldlinien von der Sensorelektrode um die (auf gleichem Potenzial befindliche) Schirmelektrode herum verlaufen und die Sensierung wird verbessert. Die Einkopplung der Schirmung zwischen der Sensorelektrode und der Referenzelektrode verringert die Einwirkungen der in der Sensorauswerte- und Steuerschaltung fließenden Ströme oder anliegenden Spannungen auf die Sensorelektrode.

Das Dokument US 2011/0001549 A1 offenbar eine Sensoranordnung mit einer Sensorelektrode, einer Richtelektrode und einer Referenzelektrode. Das Potential der Schirmelektrode wird bei dieser Einrichtung auf das Potential der Sensorelektrode eingestellt.

Die EP 0 518 836 A1 offenbar eine weitere Sensoranordnung, bei der ebenfalls das Potenzial der Schirmelektrode dem Potenzial der Sensorelektrode folgt.

Die EP 1 164 240 A2 beschreibt schließlich eine weitere Sensoranordnung.

Der Einfluss auf die Empfindlichkeit der Sensierung ist jedoch nicht bei allen äußeren Bedingungen ausreichend.

Es ist deshalb eine Aufgabe der Erfindung, eine einfache Möglichkeit zum Verändern der Empfindlichkeit der Annäherungssensoranordnung zu schaffen.

Die Aufgabe wird erfindungsgemäß durch ein Verfahren mit den Merkmalen des Anspruchs 1 gelöst.

Eine Sensoranordnung zur Ausführung des Verfahrens weist zunächst eine Sensorauswerte- und Steuerschaltung auf. Außerdem ist eine Referenzelektrode mit der Sensorauswerte- und Steuerschaltung gekoppelt. Ebenfalls mit der Sensorauswerte- und Steuerschaltung gekoppelt ist eine Sensorelektrode eines kapazitiven Sensors zum Erfassen einer Annäherung eines Objekts.

Die Sensorauswerte- und Steuerschaltung ist zur Erfassung der Kapazität zwischen Sensorelektrode und Referenzelektrode ausgebildet ist. Zusätzlich zu der der Sensorelektrode und der Referenzelektrode ist eine Richtelektrode, welche mit der Steuerschaltung gekoppelt ist, in ihrem Potenzial bzw. der Spannung gegenüber der Referenzelektrode einstellbar.

Die Sensorauswerte- und Steuerschaltung ist derart ausgebildet, dass in Abhängigkeit von den durch die Sensorauswerte- und Steuerschaltung erfassten Messdaten, welche von der Sensorelektrode abgeleitet werden, das Potenzial der Richtelektrode veränderbar ist, um die Empfindlichkeit der Sensoranordnung zu verändern.

Gemäß dem erfindungsgemäßen Verfahren zur Erfassung einer Annäherung eines Bedieners wird die Anordnung mit einer Sensorauswerte- und Steuerschaltung verwendet, mit einer Referenzelektrode, welche mit der Sensorauswerte- und Steuerschaltung gekoppelt ist. Außerdem ist eine mit der Sensorauswerte- und Steuerschaltung gekoppelte Sensorelektrode eines kapazitiven Sensors zum Erfassen einer Annäherung eines Objekts vorgesehen.

Mit Hilfe der Sensorauswerte- und Steuerschaltung wird die Kapazität zwischen Sensorelektrode und Referenzelektrode erfasst. Eine zusätzlich zu der Sensorelektrode und der Referenzelektrode angeordnete Richtelektrode ist mit der Steuerschaltung gekoppelt, um das Potential der Richtelektrode einzustellen.

Erfindungsgemäß werden Messdaten, welche repräsentativ für die Kapazität der Sensorelektrode gegenüber der Referenzelektrode sind, mit Hilfe der Sensorauswerte- und Steuerschaltung erfasst und ausgewertet. Die Sensitivität der Elektrodenanordnung wird durch Erhöhen oder Verringern des Potenzials der Schirmelektrode (oder auch der Spannung der Schirmelektrode gegenüber der Referenzelektrode) in Abhängigkeit von den Messdaten verändert.

Die Form und die Anordnung der Sensorelektrode (oder mehrerer Sensorelektroden) ist primär vom gewünschten Einsatzzweck des kapazitiven Annäherungssensors abhängig, insbesondere von den konstruktiven Gegebenheiten am Ort der Anordnung der Sensorelektrode, von der gewünschten Empfindlichkeit und von den am Einsatzort zu erwartenden Umgebungsbedingungen. Die Sensorelektrode kann als flaches Band, als leitendes Element eines Kabels oder als Bestandteil eines Koax-Kabels (insbes. Außenleiter) ausgebildet sein. Die oben genannten Verweise geben mögliche Gestaltungen einer Sensorelektrode an.

Wesentlich ist, dass die Sensorelektrode in einem einer Benutzung zugewandten Bereich angeordnet ist, damit in den Erfassungsbereich eintretende Körper das Dielektrikum um die Sensorelektrode verändern. Denn diese Veränderung des Dielektrikums, welches von den Feldlinien zwischen Sensorelektrode und Referenzelektrode durchgriffen wird, verändert auch die Kapazität der Anordnung und resultiert in erfassbaren Messänderungen.

Der Begriff "Richtelektrode" ist im Rahmen dieser Anmeldung so zu verstehen, dass elektrische Felder durch den Einfluss dieser Elektrode beeinflusst, verzerrt und ausgerichtet werden können.

Die Richtelektrode wird im Zusammenhang mit anderen Anmeldungen und bei eingeschränkter Funktionalität auch als "Schirmelektrode" oder "Shield Electrode" bezeichnet. Im Rahmen dieser Erfindung geht die Funktion der Richtelektrode jedoch über die Funktion einer Schirmelektrode hinaus, so dass hier ein anderer Begriff verwendet wird, welcher den Begriff der Richtelektrode erweitert.

Das Potenzial der Richtelektrode kann im Rahmen der Erfindung abweichend von dem Potenzial der Sensorelektrode gewählt werden und diesem nicht nur folgen, sondern deutlich davon abweichen. Daher wird auch das elektrische Feld in Anpassung an die äußeren Verhältnisse abweichend modifiziert. Daher geht der Begriff der Richtelektrode weiter als derjenige der Schirmelektrode.

Das grundsätzliche Konzept, wie die Kapazität einer Sensoranordnung erfasst wird, um Änderungen der Kapazität bei Eindringen von Körpern in den Erfassungsbereich zu detektieren ist, z.B. aus oben genannten Dokumenten bekannt. Eine beispielhafte Schaltung, welche zum Erfassen der Kapazität geeignet ist, ist in der EP 2 013 631 A2 offenbart.

Der Weg zur Erfassung der Kapazität besteht gemäß einem erprobten Stand darin, dass die mit der Sensorelektrode gekoppelte Steuer- und Auswerteschaltung eine Änderung der Kapazität der Sensorelektrode gegenüber einem Potenzial der Referenzelektrode erfasst (z.B. dem Masse-Potential), indem sie die Sensorelektrode mit einer vorgegebenen Frequenz periodisch wiederholt mit einem vorgegebenen ersten Potential, beispielsweise einem Betriebsspannungspotential, koppelt und wenigstens einen Parameter eines vom periodischen Laden und Entladen der Sensorelektrode abhängigen Strom- und Spannungsverlaufs zur Erfassung der Kapazitätsänderung auswertet. Der Spannungsverlauf kann beispielsweise der Spannungsverlauf am Anschluss der Sensorelektrode sein. Der Parameter kann beispielsweise eine Spannung, die über einen Ladung ansammelnden Kondensator gemessen wird, oder eine bestimmte Anzahl von Perioden des Ladens und Entladens bis zum Überschreiten einer Schaltschwelle durch eine an der Sensorelektrode gemessene Spannung sein.

Diese Erfassung wird wiederholt, so dass eine Veränderung des Dielektrikums, z.B. durch zugreifende Benutzer, in einer sprunghaften Änderung des Parameters führt. Häufig wird der Parameter durch einen mitlaufenden Mittelwert angepasst, so dass langsam veränderliche Umwelteinflüsse, die jedoch auch die Kapazität beeinflussen, in dem gleitenden Mittelwert berücksichtigt werden. Nur ein Wert, der signifikant von dem gleitenden Mittelwert abweicht, wird als Zugriff oder Annäherung erkannt.

An diesem Konzept der Kapazitätserfassung ändert die Erfindung nichts, da die Richtelektrode nicht unmittelbar in den Messvorgang einwirkt. Die Veränderung der Spannung der Richtelektrode hat zwar Einfluss auf die ermittelten Werte, deren Erfassung erfolgt jedoch wie bei kapazitiven Einrichtungen gemäß dem Stand der Technik. Da dieser Aspekt der Messung von Kapazitäten bekannt und für die Erfindung nicht wesentlich ist, wird ausdrücklich auf diese Offenbarungen verweisen, um einen möglichen Weg für die Kapazitätsermittlung zu vermitteln.

Ein wesentliches Element der Erfindung besteht darin, das bisherige Konzept der Schirmelektrode zu erweitern und die Schirmelektrode als Richtelektrode zur gezielten Beeinflussung der Sensitivität der Sensoranordnung zu verwenden.

Die Richtelektrode kann grundsätzlich in ihrer Basisfunktion dieselbe Wirkung entfalten wie eine Schirmelektrode. Dann wird das Potenzial der Richtelektrode dem Potenzial der Sensorelektrode nachgeführt, also dasselbe Potenzial der Richtelektrode eingestellt, wie es bei der Sensorelektrode vorliegt. Wird jedoch anhand der Messwerte ermittelt, dass die Sensitivität der Sensoranordnung von dem vorgegebenen Sollbereich abweicht, wird das Potenzial der Richtelektrode gegenüber der Sensorelektrode geändert.

Die Richtelektrode bewirkt durch diese Potenzialänderung eine Umformung der Feldlinien, welche zwischen Sensorelektrode und Referenzelektrode, ggf. an der Richtelektrode vorbei verlaufen. Das Potenzial der Richtelektrode kann gegenüber der Sensorelektrode sowohl erhöht, als auch verringert werden, regelmäßig wird jedoch als untere Grenze das Potenzial der Sensorelektrode verwendet werden. Wir das Potenzial der Richtelektrode gegenüber der Sensorelektrode erhöht, so werden die Feldlinien zwischen Sensorelektrode und Referenzelektrode aus einem Raumbereich um die Richtelektrode gedrängt und aufgeweitet. Ist die Richtelektrode zwischen Sensorelektrode und Referenzelektrode angeordnet, so drückt eine Potenzialerhöhung der Richtelektrode über das Potenzial der Sensorelektrode hinaus beispielweise die Feldlinien des elektrischen Feldes weiter nach außen (siehe unten). Das elektrische Feld, welches durch die Kapazitätsmessung ausgewertet wird, kann in seiner Erstreckung und Form demnach durch die vom eigentlichen Messvorgang nicht betroffene Richtelektrode verändert werden.

Wann eine Veränderung des Potenzials der Richtelektrode gegenüber der Sensorelektrode vorgenommen wird, hängt von dem Verfahren der Auswertung der Kapazität der Sensorelektrode ab.

Wird das vorstehend beschriebene Verfahren gewählt, so wird die Kapazität, bestehend aus Referenzelektrode-Sensorelektrode, mit hoher Frequenz nach und nach geladen. Je nachdem, welche Zeitdauer für die Aufladung erforderlich ist, wann also ein Spannungswert an der Kapazität einen Schwellwert übersteigt, kann durch die Auswerteschaltung ein Wert für die Kapazität ermittelt werden. Wird festgestellt, dass die Anzahl von Ladezyklen (Burst-Länge) aus einem vorgegebenen SollBereich abweicht (die kann über eine Mehrzahl von Ladezyklen gemittelt werden), so ist dies ein Indiz für eine ungeeignet eingestellte Sensitivität der Anordnung. Eine Kapazitätsänderung kann zwar auch ein Hinweis auf eine Betätigung bzw. Annäherung sein, eine Änderung, die zur Anpassung des Potenzials der Richtelektrode führt findet jedoch bei deutlich längeren Zeitkonstanten statt als die Änderung aufgrund einer Annäherung. Beispielsweise kann die Mittelung der erforderlichen Ladezyklen über mehrere Sekunden oder sogar Minuten erfolgen, um veränderlichen Umwelteinflüssen (Witterung etc.) Rechnung zu tragen.

Dauert es nach dieser Auswertung z.B. zu lange, bis die vorgegebene Ladeschwelle erreicht wird, so wird die Spannung der Richtelektrode verändert, um die Feldlinien von Sensorelektrode zu Referenzelektrode zu beeinflussen und die Sensitivität der Anordnung zu verändern. Erfindungsgemäß wird das Messfeld gezielt geformt, ohne am Messprinzip jedoch etwas ändern zu müssen. Bei einer bevorzugten Ausführungsform zur Ausführung des erfindungsgemäßen Verfahrens entspricht das Potenzial der Referenzelektrode dem Massepotenzial. Alternativ ist eine Ausführungsform denkbar, bei der das Referenzpotenzial einem Spannungsversorgungspotenzial oder einem konstanten, zwischen dem Spannungsversorgungspotenzial und Masse liegenden Zwischenpotenzial entspricht.

Die Anordnung und auch der Abstand der Richtelektrode von der Sensorelektrode und die Ausrichtung der Elektroden zueinander sowie auch die Form der Richtelektrode selbst können in Abhängigkeit vom Einsatzgebiet stark variieren. Beispielsweise können die Richtelektrode wie auch die Sensorelektroden als Platten oder Metallschichten ausgebildet sein. Auch Ausbildung der Elektroden als Zylinder oder Zylinderabschnitt sowie Kugelabschnitt ist möglich, insbesondere wenn eine gezielte Feldformung durch den Einfluss der Richtelektrode und deren Form und Potenzial erreicht werden soll. Insbesondere können neben der ersten Richtelektrode auch weitere Richtelektroden an weiteren Positionen angeordnet sein, um dem Feld eine komplexere Form zu geben, wobei diese sogar mit unterschiedlichen Potenzialen belegt werden können.

Bei den Sensoranordnungen mit Schirmelektrode wird diese meist zwischen Sensor- und Referenzelektrode angeordnet. Dies kann auch gemäß der Erfindung erfolgen, wenn die Richtelektrode zwischen Sensor- und Referenzelektrode platziert wird. Die Richtelektrode kann jedoch auch eine andere Position und Geometrie einnehmen, z.B. um gezielt in Abschnitten der Sensorelektrode das elektrische Feld zu verzerren.

Vorzugsweise wird das Potenzial der Sensorelektrode und der Referenzelektrode gepulst verändert.

Die Ansteuerung und Auswertung in der Praxis erfolgt oft bei dynamischen, nicht bei statischen Feldern, wie oben bei Verweis auf ein mögliches Messprinzip angedeutet. Es wird eine Potenzialveränderung der Elektrodenanordnungen mit hoher Frequenz durchgeführt. Dies bietet den Vorteil, dass die Lade- und Entladevorgänge, die zwischen den Spannungspulsen zur Umladung der beteiligten Kapazitäten auftreten, überwacht und zur Auswertung der Kapazitätswerte verwendet werden können. Die Frequenzen betragen oft einige kHz bis einige hundert kHz und erlauben eine zeitaufgelöste Erfassung der Kapazität.

Vorzugsweise werden die Sensorelektrode und die Richtelektrode mit identischer Frequenz und Phase mit Spannung gegenüber der Referenzelektrode beaufschlagt bzw. ihr Potenzial wird mit identischer Frequenz und Phase eingestellt.

In diesem Fall können die Taktung und die Ansteuerung der Sensorelektrode und der Richtelektrode mit einem gemeinsamen System gesteuert werden, wobei die Potenziale der Elektroden jedoch unterschiedlich sein können.

In einer Weiterbildung der Erfindung ist die Phasenlage der Ansteuerung der Sensorelektrode mit Spannungspulsen gegenüber den Spannungspulsen an der Richtelektrode verschoben.

Es hat sich gezeigt, dass durch eine Verschiebung der (verschiedenen) Spannungspulse an Sensorelektrode und Richtelektrode gegeneinander das Erfassungsverhalten weiter beeinflusst werden kann. Die Spannungspulse an der Sensorelektrode können denen an der Richtelektrode sowohl vorauseilen, als auch zurückbleiben. Auch die Pulslänge kann unterschiedlich ausgewählt werden, der Puls zur Potenzialeinstellung der Sensorelektrode kann kürzer oder länger als derjenige der Richtelektrode sein und außerdem diesem vorauseilen oder hinter ihm zurückbleiben.

Vorteilhafte und/oder bevorzugte Weiterbildungen der Erfindung sind in den Unteransprüchen gekennzeichnet.

Im Folgenden wird die Erfindung anhand von in den Zeichnungen dargestellten bevorzugten Ausführungsformen näher beschrieben. In den Zeichnungen zeigen:
Fig. 1a und 1b Anordnung zur Ausführung des erfindungsgemäßen Verfahrens in einer ersten Ausführungsform mit jeweils verschiedenen Elektrodenpotenzialen;
Fig. 2 eine schematische Darstellung eines Messverlaufs und der Vorgabe der Änderung einer Spannung an der Richtelektrode;

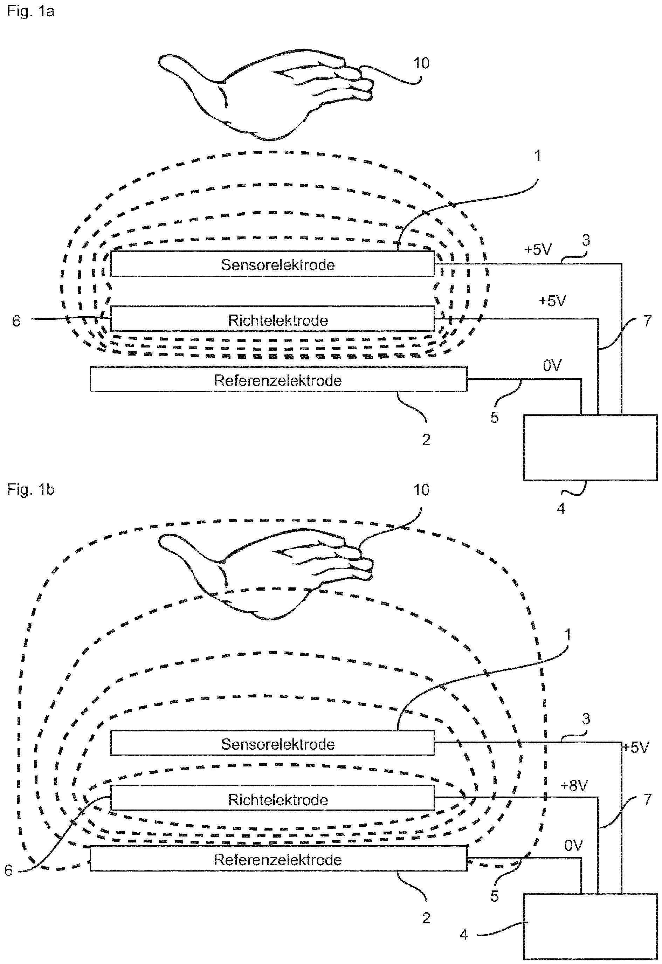

Figur 1a zeigte eine schematische Darstellung eine Annäherungssensoranordnung zur Ausführung der Erfindung. Der kapazitive Annäherungssensor umfasst wenigstens eine Sensorelektrode 1, die beabstandet zu einer Massefläche 2 angeordnet ist. Die Sensorelektrode 1 und die Massefläche 2 sind in der schematischen Darstellung der Figur 1 als rechteckige Platten dargestellt. In der Praxis wird die Massefläche 2 von einer leitenden Oberfläche beliebiger Gestaltung, beispielsweise von einem Karosseriebauteil, oder auch von einer Metallisierungsebene einer Leiterplatte gebildet. Die Sensorelektrode 1 kann ebenfalls nahezu beliebige Formen annehmen. Vorzugsweise handelt es sich jedoch um einen Draht, ggf. mit Ummantelung oder um den Leiter eines Koax-Kabels. Die Sensorelektrode 1 ist mit wenigstens einer Anschlussleitung 3 verbunden, welche die Sensorelektrode 1 mit einer Steuerschaltung 4 koppelt, wobei die Steuerschaltung 4, welche auch als Ansteuerelektronik bezeichnet wird, in Figur 1 als Block dargestellt ist. Die Steuerschaltung 4 enthält unter anderem eine Auswerteelektronik oder Messschaltung zum Bestimmen der Kapazität der Sensorelektronik gegenüber einer Masse. Die Steuerschaltung 4 ist bei der in Figur 1 schematisch dargestellten Ausführungsform über eine weitere Anschlussleitung 5 mit der Masse in Form der Massefläche 2 verbunden. Zwischen der Sensorelektrode 1 und der Masse ist eine bestimmte Kapazität messbar, die einerseits von Form und Anordnung der Sensorelektrode gegenüber der Massefläche 2 und andererseits sowohl von dem zwischen der Sensorelektrode 1 und der Massefläche 2 angeordneten Medium als auch von den sich in der Umgebung der Sensorelektrode 1 aufhaltenden Objekten abhängig ist. Wenn über die Anschlussleitungen 3 und 5 zwischen der Sensorelektrode 1 und der Massefläche 2 eine Spannung angelegt wird, so bildet sich zwischen der Sensorelektrode 1 und der Masse ein elektrisches Feld aus, welches normalerweise dort, wo die Sensorelektrode 1 den geringsten Abstand von der Massefläche 2 hat, seine höchste Dichte (höchste Feldstärke) annimmt. Das stärkste elektrische Feld würde sich direkt in dem Spalt zwischen der Sensorelektrode 1 und der Massefläche 2 ausbilden, und nur ein geringer Teil des elektrischen Feldes würde in den Umgebungsraum hineinreichen. Dieses wiederum würde bedeuten, dass Änderungen der sich im Raum befindenden Objekte einen relativ geringen Einfluss auf das elektrische Feld und somit die zwischen Sensorelektrode 1 und Massefläche 2 gemessene Kapazität haben würden. Um die Empfindlichkeit des kapazitiven Sensors zu erhöhen ist zwischen der Sensorelektrode 1 und der Massefläche 2 eine Richtelekrode 6 angeordnet. Die Richtelekrode 6 ist über eine Zuleitung 7 ebenfalls mit der Steuerschaltung 4 verbunden. Die Steuerschaltung 4 sorgt dafür, dass das Potenzial der Richtelekrode 6 unter Berücksichtigung der Messwerte unabhängig von dem Potenzial der Sensorelektrode 1 geführt wird. Die Folge des Einsatzes einer solchen Richtelekrode 6 mit entsprechender Ansteuerung ist dann, dass sich kein starkes elektrisches Feld mehr in dem Spalt zwischen Sensorelektrode 1 und Massefläche 2 ausbildet, sondern sich das Feld primär in den Raum oberhalb der Sensoranordnung hinein ausbreitet. Dies wiederum führt zu einer stärkeren Abhängigkeit der Feldstärke bzw. der Kapazität der gesamten Anordnung von den sich in dem Raum befindenden Objekten, das heißt zu einer höheren Empfindlichkeit des kapazitiven Annäherungssensors.

Die Steuerschaltung 4 enthält eine Messschaltung zum Messen der Kapazität der wenigstens einen Steuerelektrode 1 gegenüber der Massefläche 2. Um diese Kapazität zu messen, gibt es verschiedene Vorgehensweisen. Bei den meisten Verfahren wird eine sich ändernde Spannung zwischen der Sensorelektrode 1 und der Masse 2 angelegt, was wiederum bedeutet, dass das Potenzial der Richtelekrode 6 unter Berücksichtigung des Potenzials der Sensorelektrode 1, jedoch ggf. ungleich zu diesem nachgeführt werden muss. Die grundsätzlichen Vorgehensweisen beim Messen der Kapazität und beim Nachführen des Potenzials sind aus dem Stand der Technik bekannt, beispielsweise aus den Druckschriften EP 1 164 240 A2, EP 0 518 836 A1, DE 196 81 725 D4 oder DE 10 2006 044 778 A1. Die Messprinzipien und die Technik des Nachführens des Potenzials der Richtelekrode sollen hier deshalb nicht näher beschrieben werden.

Fig. 1a zeigt die Feldlinien in einer Situation, wo die Richtelektrode und die Sensorelektrode auf gleichem Potenzial gegenüber der Referenzelektrode liegen. Dieser Fall ist identisch zu den bereits bekannten Schirmelektroden, die in ihrem Potenzial der Sensorelektrode nachgeführt werden. In diesem Beispiel beträgt eine Spannungsdifferenz zwischen Sensorelektrode und Referenzelektrode sowie zwischen Richtelektrode und Referenzelektrode 5V.

Fig. 1b zeigt die Feldlinienverteilung, wenn das Potenzial der Richtelektrode gegenüber dem der Sensorelektrode erhöht wird. Die Spannung Sensorelektrode-Referenzelektrode beträgt weiterhin 5V. Die Spannung Richtelektrode-Referenzelektrode beträgt jedoch 8V. Die Feldlinien von der Sensorelektrode zu der Referenzelektrode werden von der zusätzlichen Feldverzerrung weiter in den Außenraum gedrängt. Die Feldlinien werden dabei zwar in ihrem Abstand aufgeweitet, durchgreifen jedoch einen größeren Raum. Die Kapazität zwischen Sensor- und Referenzelektrode wird beeinflusst. Da die Spannung an der Richtelektrode in Abhängigkeit von den wiederholt ermittelten Messdaten erfolgt, kann die Sensitivität und Kapazität bedarfsabhängig eingestellt werden.

Zwischen Fig. 1a und Fig. 1b besteht der einzige Unterschied darin besteht, dass die Spannung zwischen Richtelektrode und Referenzelektrode vergrößert wurde. Das Objekt 10, welches in Fig. 1a nicht von Feldlinien durchgriffen wurde, wird bei erhöhter Spannung jedoch erfasst.

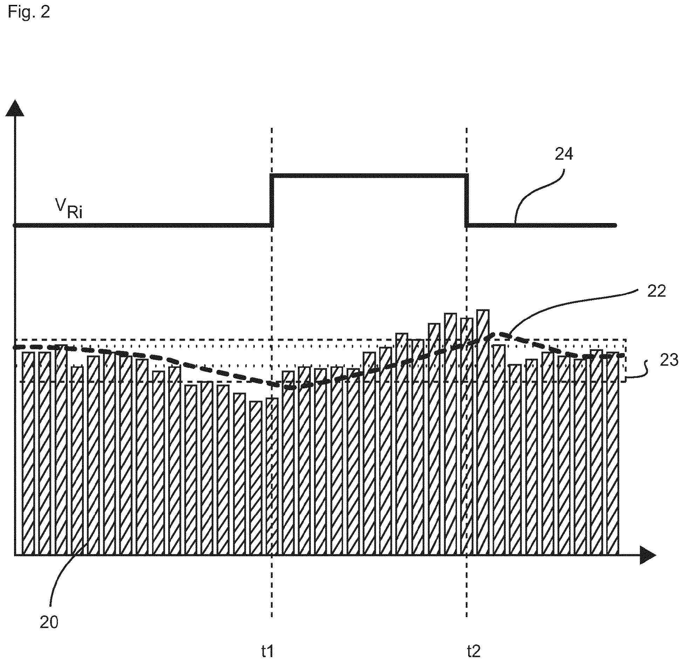

Fig. 2 zeigt schematisch, wie eine mögliche Regelung für die Spannung der Richtelektrode erfolgen kann.

Wiederholt wird über die Mess- und Auswerteschaltung die aktuelle Kapazität der Sensoranordnung Sensorelektrode-Referenzelektrode erfasst. Wie oben beschrieben, wird hierfür beispielsweise die Zeitdauer ermittelt, die bis zum Aufladen des Kondensators auf einen vorgegebenen Ladezustand (bis zum Erreichen einer Schwellwertspannung am Kondensator) erforderlich ist. Diese Zeiten sind als vertikale Balken 20 in dem Diagramm dargestellt.

Ein gleitender Mittelwert 22 glättet Schwankungen der Einzelmessungen und erlaubt eine Aussage über die Tendenz der Kapazitätsentwicklung über mittlere und längere Zeitdauern (einige Zehntel-Sekunden bis zu mehreren Sekunden oder sogar Minuten) .

Ein akzeptabler Wertebereich für den gleitenden Mittelwert ist durch den Bereich 23 (gepunktet) dargestellt. Der gleitende Mittelwert sollte innerhalb der Grenzen dieses Bereichs verlaufen. Zum Zeitpunkt t1 verlässt der gleitende Mittelwert 22 diesen Bereich 23, da die Einzelmessungen dauerhaft unterhalb dieses Bereichs abgesunken sind. Dies kann darauf hindeuten, dass sich die Umweltbedingungen (z.B. Witterung) derart geändert haben, dass die Kapazität des Sensors abgenommen hat, so dass kürzere Ladezeiten erfasst werden.

Die Spannung der Richtelektrode V_{Ri} wird darauf hochgeregelt, z.B. in 1V Schritten. Das Elektrische Feld zwischen Sensorelektrode und Referenzelektrode wird dadurch verformt bzw. neu ausgerichtet. Dies resultiert aus der geänderten Ladungsverteilung auf den Elektroden. Die Messwerte 20 erhöhen sich sofort wieder in den Sollbereich 23, kurz darauf erreicht auch der gleitende Durchschnitt 22 den Sollbereich.

Zum Zeitpunkt t2 tritt der gleitende Durchschnitt jedoch nach oben aus dem Bereich 23 heraus, woraufhin die Auswerteschaltung eine Verringerung der Spannung V_{Ri} auslöst. Erneut bewegen sich die Messwerte wieder in den Sollbereich.

Der Bereich 23 wird vorzugsweise empirisch für die jeweilige Sensorausbildung ermittelt, ebenso wie die Stufung der Spannungserhöhung an der Richtelektrode.

Wesentlich ist, dass eine an der Messauswertung unbeteiligte Elektrode zur Feldformung eingesetzt wird, wobei ihr Potenzial zwar unter Berücksichtigung, aber abweichend von den Potenzialen der übrigen Elektroden eingestellt werden kann, um die Sensitivität der Sensoranordnung zu verändern.

## Patentansprüche

1. Verfahren zur Erfassung einer Annäherung eines Bedieners, wobei eine Anordnung verwendet wird, mit
einer Sensorauswerte- und Steuerschaltung (4),
einer Referenzelektrode (2), welche mit der Sensorauswerte- und Steuerschaltung (4) gekoppelt ist,
einer mit der Sensorauswerte- und Steuerschaltung (4) gekoppelten Sensorelektrode (1) eines kapazitiven Sensors zum Erfassen einer Annäherung eines Objekts (10), wobei die Sensorauswerte- und Steuerschaltung (4) zur Erfassung der Kapazität zwischen Sensorelektrode (1) und Referenzelektrode (2) ausgebildet ist,
einer zwischen der Sensorelektrode (1) und der Referenzelektrode (2) angeordneten Richtelektrode (6), welche mit der Steuerschaltung (4) gekoppelt ist, um das Potential der Schirmelektrode einzustellen,
aufweisend die Schritte:
erfassen von Messdaten bezüglich der Kapazität der Sensorelektrode (1) gegenüber der Referenzelektrode (2) mit Hilfe der Sensorauswerte- und Steuerschaltung (4),
**gekennzeichnet durch** die Schritte:
Auswerten der Messdaten und Bestimmen eines für die Sensitivität der Sensoranordnung charakteristischen Wertes aus einer Zeitfolge der Messdaten,
Erhöhen oder Verringern des Potenzials der Richtelektrode (6) in Abweichung zu dem Potenzial der Sensorelektrode und in Abhängigkeit von dem charakteristischen Wert, um die Empfindlichkeit der Sensoranordnung zu verändern.

2. Verfahren nach Anspruch 1, wobei der für die Sensitivität der Sensoranordnung charakteristische Wert aus einem gleitenden Mittelwert der Kapazitätswerte abgeleitet wird.

3. Verfahren nach Anspruch 1 oder 2, wobei die Sensorelektrode und die Richtelektrode gepulst bei identischer Frequenz mit Spannung beaufschlagt werden und wobei in Abhängigkeit von dem charakteristischen Wert die Phasenlage der Spannungspulse an der Sensorelektrode und der Richtelektrode verändert wird, um die Sensitivität der Sensoranordnung zu verändern.

## Claims

1. A method for detecting an approach of an operator, an arrangement being used, having
a sensor analysis and control circuit (4),
a reference electrode (2), which is coupled to the sensor analysis and control circuit (4),
a sensor electrode (1), coupled to the sensor analysis and control circuit (4), of a capacitive sensor for detecting an approach of an object (10), the sensor analysis and control circuit (4) being constructed for detecting the capacitance between sensor electrode (1) and reference electrode (2),
an adjustment electrode (6) arranged between the sensor electrode (1) and the reference electrode (2), which is coupled to the control circuit (4) in order to adjust the potential of the shield electrode,
having the steps:
detecting measurement data relating to the capacitance of the sensor electrode (1) with respect to the reference electrode (2) with the aid of the sensor analysis and control circuit (4),
**characterized by** the steps:
analysing the measurement data and determining a value characteristic for the sensitivity of the sensor arrangement from a temporal sequence of the measurement data,
increasing or decreasing the potential of the adjustment electrode (6) in deviation from the potential of the sensor electrode and as a function of the characteristic value, in order to change the sensitivity of the sensor arrangement.

2. The method according to Claim 1, wherein the value characteristic for the sensitivity of the sensor arrangement is derived from a sliding average value of the capacitance values.

3. The method according to Claim 1 or 2, wherein the sensor electrode and the adjustment electrode are loaded with voltage in a pulsed manner at identical frequency and wherein the phase position of the voltage pulses at the sensor electrode and the adjustment electrode is changed as a function of the characteristic value, in order to change the sensitivity of the sensor arrangement.

## Revendications

1. Procédé, destiné à détecter une approche d'un opérateur, un agencement étant utilisé, comprenant
un circuit d'évaluation de capteur et de commande (4),
une électrode de référence (2), laquelle est connectée sur le circuit d'évaluation de capteur et de commande (4),
une électrode de capteur (1) d'un capteur capacitif, connectée sur le circuit d'évaluation de capteur et de commande (4), destinée à détecter une approche d'un objet (10), le circuit d'évaluation de capteur et de commande (4) étant conçu pour détecter la capacité entre l'électrode de capteur (1) et l'électrode de référence (2),
une électrode directrice (6), placée entre l'électrode de capteur (1) et l'électrode de référence (2), laquelle est connectée sur le circuit de commande (4), pour régler le potentiel de l'électrode de blindage,
comportant les étapes consistant à :
détecter des données de mesure concernant la capacité de l'électrode de capteur (1) par rapport à l'électrode de référence (2) à l'aide du circuit d'évaluation de capteur et de commande (4),
**caractérisé par** les étapes, consistant à :
évaluer les données de mesure et déterminer une valeur caractéristique pour la sensitivité de l'agencement de capteurs à partir d'une séquence temporelle des données de mesure,
relever ou réduire le potentiel de l'électrode directrice (6) en discordance avec le potentiel de l'électrode de capteur et en fonction de la valeur caractéristique, pour modifier la sensibilité de l'agencement de capteurs.

2. Procédé selon la revendication 1, la valeur caractéristique pour la sensitivité de l'agencement de capteurs étant dérivée d'une valeur moyenne mobile des valeurs de capacité.

3. Procédé selon la revendication 1 ou 2, l'électrode de capteur et l'électrode directrice étant soumises à des impulsions de tension à fréquence identique et en fonction de la valeur caractéristique, la position de phase des impulsions de tension étant modifiée sur l'électrode de capteur et sur l'électrode directrice, pour modifier la sensitivité de l'agencement de capteurs.
